# EUROPEAN PATENT APPLICATION

(11) **EP 4 250 010 A1**
(43) Date of publication of application: **27.09.2023**
(21) Application number: 22164333.1
(22) Date of filing: 25.03.2022
(51) Int. Cl.: G03F 7/20, G01N 21/956, G02F 1/35

(54) **APPARATUS AND METHODS FOR FILTERING MEASUREMENT RADIATION**

(71) Applicant: ASML Netherlands B.V., 5500 AH Veldhoven (NL)
(72) Inventor: REININK, Johan, 5500 AH Veldhoven (NL); DONDERS, Sjoerd, Nicolaas, Lambertus, 5500 AH Veldhoven (NL); PORTER, Christina, Lynn, 5500 AH Veldhoven (NL); COENEN, Teis, Johan, 5500 AH Veldhoven (NL); DEURLOO, Jos, Henders, Bastiaan, 5500 AH Veldhoven (NL)
(74) Representative: ASML Netherlands B.V.

(57) **Abstract**

An apparatus for measuring a parameter of a structure related to a semiconductor manufacturing process. The apparatus comprises a source assembly configured to provide measurement radiation having one or more first wavelengths for irradiating the structure on a substrate. The apparatus further comprises a filter arranged to receive scattered measurement radiation that has scattered from the structure, wherein the filter is configured to transmit the scattered measurement radiation at the one or more first wavelengths and filter out radiation at one or more second wavelengths. The filter comprises a film with a curvature in at least one direction. The apparatus further comprises a plurality of detectors, located downstream of the filter, configured to detect the filtered scattered radiation configured to measure the parameter of the structure.

## Description

### FIELD

The present invention relates to apparatus and methods for metrology and/or detection of a structure related to a lithographic process. Specifically, it relates to filtering radiation other than metrology radiation.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = k1×λ/NA, where λ is the wavelength of radiation employed, NA is the numerical aperture of the projection optics in the lithographic apparatus, CD is the "critical dimension" (generally the smallest feature size printed, but in this case half-pitch) and ki is an empirical resolution factor. In general, the smaller ki the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

Examples of known scatterometers often rely on provision of dedicated metrology targets. For example, a method may require a target in the form of a simple grating that is large enough that a measurement beam generates a spot that is smaller than the grating (i.e., the grating is underfilled). In socalled reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating medium, thereby generating an emitted radiation, optionally a high harmonic generation comprising high frequency radiation.

The radiation used during metrology may be used to irradiate a structure on a substrate, such as a lithographic pattern deposited onto a wafer. Once the radiation has interacted with the structure, it may be collected by one or more detectors for measurement and analysis. In order to obtain a high quality measurement and reduce the effects of noise, it may be beneficial to avoid radiation other than the measurement radiation from hitting the detectors. The detectors take up a finite amount of space, and therefore their placement may be limited. Limiting factors may for example include requirements on the path(s) of radiation in vicinity of the structure, and/or positions of other nearby elements of the apparatus (e.g. other detectors, or other components of the apparatus). It is an aim of the present disclosure to provide improvements for at least some of the challenges related to controlling and detecting measurement radiation.

### SUMMARY

According to a first aspect of the disclosure, there is provided an apparatus for measuring a parameter of a structure related to a semiconductor manufacturing process. The apparatus comprises a source assembly configured to provide measurement radiation having one or more first wavelengths for irradiating the structure on a substrate. The apparatus further comprises a filter arranged to receive scattered measurement radiation that has scattered from the structure, wherein the filter is configured to transmit the scattered measurement radiation at the one or more first wavelengths and filter out radiation at one or more second wavelengths, and wherein the filter comprises a film with a curvature in at least one direction. The apparatus further comprises a plurality of detectors, located downstream of the filter, configured to detect the filtered scattered radiation configured to measure the parameter of the structure.

Optionally, substantially the entire surface of the film may be curved.

Optionally, the film may comprise two or more planar sections connected by a fold portion of the film.

Optionally, the one or more second wavelengths may be in a range from 200 nm to 10 µm.

Optionally, the radiation at one or more second wavelengths may comprise pump radiation used by the source assembly for generating the measurement radiation.

Optionally, the radiation at one or more second wavelengths may comprise stray radiation generated by one or more components of the apparatus.

Optionally, the measurement radiation may comprise one or more wavelengths in a range of 0.01 nm - 50 nm, or 0.01 nm - 20 nm, or 1 nm - 10 nm, or 10 nm - 20 nm.

Optionally, the source assembly may comprise a high harmonic generation source.

Optionally, the filter film may comprise at least one of zirconium, aluminium, carbon, boron, silicon, yttrium, silver.

Optionally, the filter film may have a thickness in a range from 50 nm to 800 nm.

Optionally, the filter film may have a thickness from 150 to 250 nm.

Optionally, the apparatus may further comprise an enclosure that is at least partially radiation-tight.

Optionally, the plurality of detectors may be located inside the enclosure.

Optionally, the structure may be located outside the enclosure.

Optionally, a surface of the enclosure may comprise one or more grooves configured to trap unwanted radiation.

Optionally, the structure may comprise a target structure comprising one or more diffracting patterns.

According to another aspect of the current disclosure there is provided an apparatus for measuring a parameter of a structure related to a semiconductor manufacturing process. The apparatus comprises a source assembly configured to provide measurement radiation having one or more first wavelengths for irradiating the structure on a substrate. The apparatus further comprises a filter arranged to receive scattered measurement radiation that has scattered from the structure, wherein the filter is configured to transmit the scattered measurement radiation at the one or more first wavelengths and filter out radiation at one or more second wavelengths, wherein the filter comprises a film with a curvature in at least one direction. The apparatus further comprises a plurality of detectors, located downstream of the filter, configured to detect the filtered scattered radiation configured to measure the parameter of the structure, and an enclosure configured to comprise the structure and the plurality of detectors, wherein the enclosure is at least partially radiation-tight for the measurement radiation wavelengths, and wherein the enclosure comprises an opening for passing radiation and wherein the filter is placed inside the opening.

According to another aspect of the current disclosure there is provided metrology tool comprising the apparatus as described above.

According to another aspect of the current disclosure there is provided an inspection tool comprising the apparatus as described above.

According to another aspect of the current disclosure there is provided a lithographic apparatus comprising an apparatus as described above.

According to another aspect of the current disclosure there is provided a litho cell comprising an apparatus as described above.

### BRIEF DESCRIPTION OF THE DRAWINGS

Embodiments will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a simplified schematic drawing of an illumination source;
- Figures 8(a) and 8(b) depict an example metrology setup using short wavelength measurement radiation 802;
- Figure 9 depicts an apparatus for measuring a parameter of a structure related to a semiconductor manufacturing process;
- Figures 10(a) and 10(b) depict a curved filter arranged to receive radiation scattered from a structure to be measured;
- Figures 11(a) and 11(b) depict a piecewise planar filter arranged to receive radiation scattered from a structure to be measured;
- Figure 12 depicts a curved filter provided in an opening of an at least partially radiation-tight enclosure; and
- Figure 13 depicts an alternative implementation with an enclosure comprising the structure inside the enclosure and with the filter placed upstream of the structure.

### DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

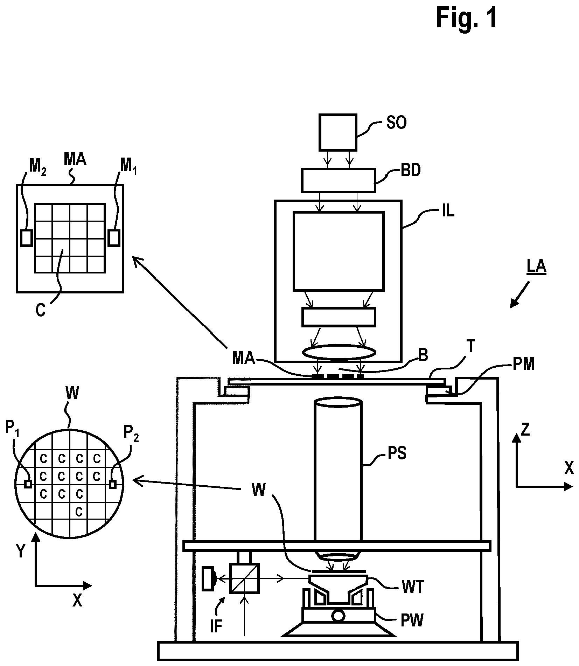

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

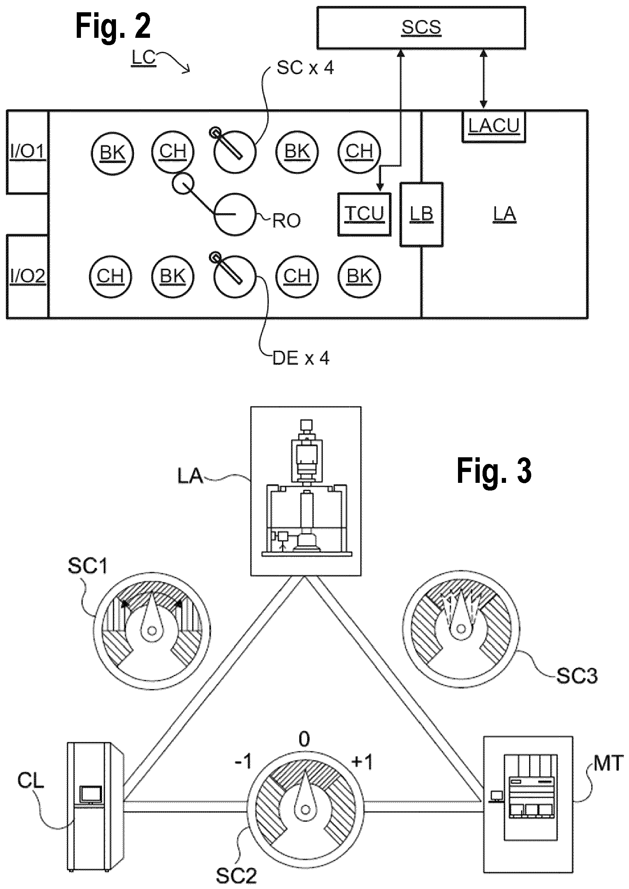

As shown in Figure 2 the lithographic apparatus LA may form part of a lithographic cell LC, also sometimes referred to as a lithocell or (litho)cluster, which often also includes apparatus to perform preand post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

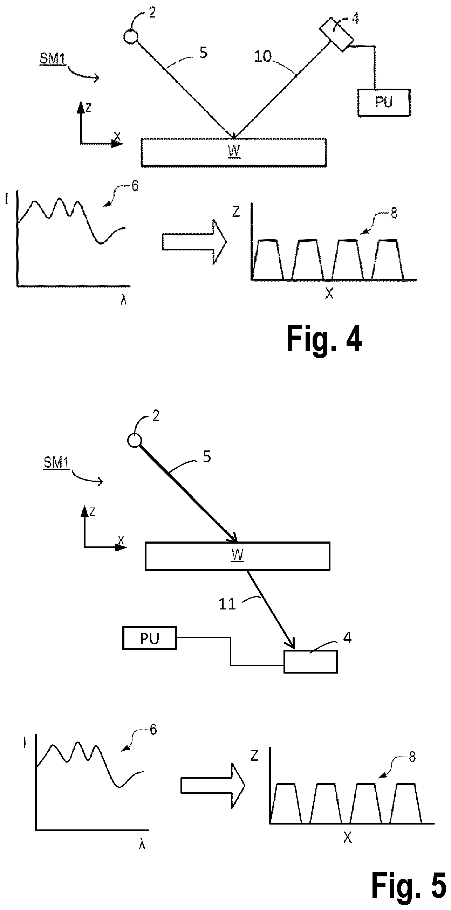

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling and x-ray mathematical model and an optical mathematical model through one or more common. The contents of the cited US patent applications are incorporated herein by reference in their entirety.

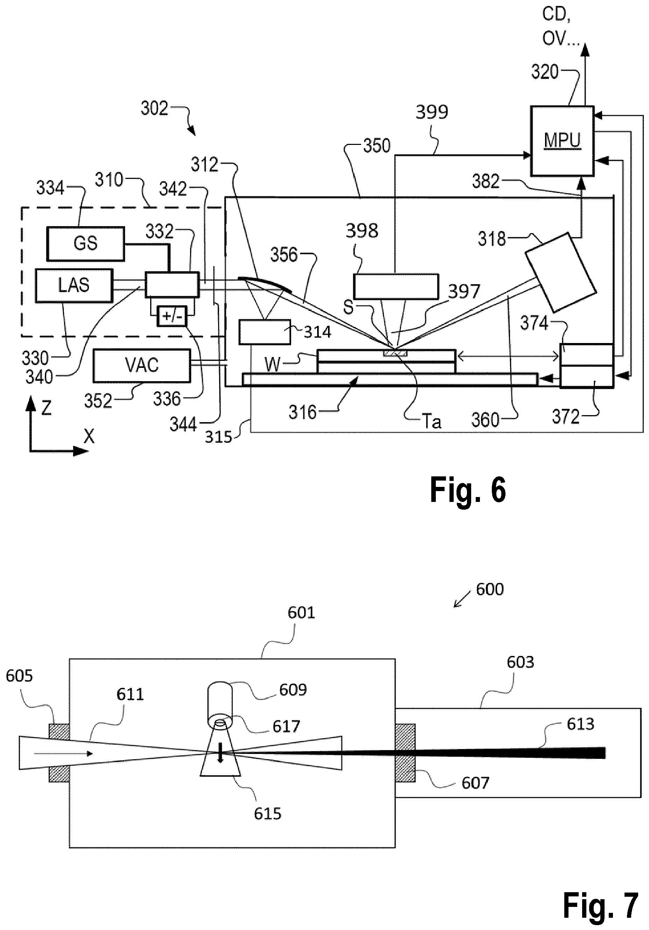

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source may be a gas jet/nozzle source, a capillary/fiber source or a gas cell source.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200 nm to 10 µm, for example in the region of 1 µm (1 micron). Optionally, the laser pulses are delivered as a first pump radiation 340 to the gas delivery system 332, where in the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen (N₂), Oxygen (O₂), Argon (Ar), Krypton (Kr), Xenon (Xe), Carbon dioxide and the combination of them. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 µm in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 310 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use High Harmonic Generation (HHG) or inverse Compton scattering (ICS) to obtain radiation at the desired wavelength(s).

Figure 7 shows a simplified schematic drawing of an embodiment 600 of an illumination source 310, which may be the illumination source for high harmonic generation (HHG). One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen (N₂), Oxygen (O₂), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUVSXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUVSXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 7 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

As described herein, metrology radiation may comprise short wavelength radiation, for example in a range from 0.1nm - 50 nm. The metrology radiation may for example comprise EUV and/or Soft X-Ray (SXR) radiation, for example in a wavelength range from roughly 0.01 nm to 100 nm, optionally 0.1 nm to 100 nm, optionally 1 nm to 100 nm, optionally 1 nm to 50 nm, or optionally 10 nm to 20 nm.

. This short wavelength ranges of metrology radiation are considerably shorter than the visible light region, which ranges around 400 nm to about 700 nm. Using shorter wavelengths may enable metrology applications on small feature sizes, where visible light would have insufficient resolution.

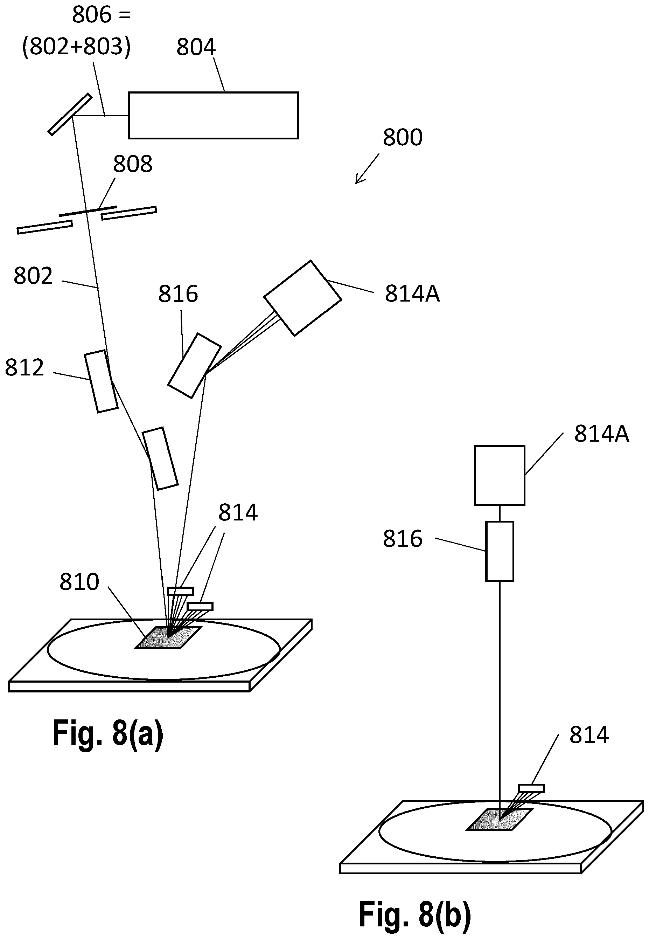

Figures 8(a) and 8(b) depict an example metrology setup 800 using short wavelength measurement radiation 802. The metrology setup may be related to a semiconductor manufacturing process. However, it is understood that other processes may be interrogated with the metrology setup 800 described herein. The short wavelength radiation may be provided by a source assembly 804. A source assembly may for example use high harmonic generation (HHG) to generate short wavelength radiation by converting pump radiation (also referred to as drive radiation) having longer wavelength(s). The pump radiation may comprise a pulsed longer wavelength (e.g. infrared) pump laser beam. The pulsed laser beam may be focused into a gaseous medium in order to generate short wavelength radiation based on nonlinear effects.

After the short wavelength generation, both the pump radiation and the short wavelength measurement radiation may have the same propagation direction. A mix 806 of pump radiation 803 and measurement radiation 802 may exit from the source assembly 804. The pump radiation 803 may be filtered out from the mixed radiation 806 (e.g. illustrated schematically by filter 808 in figure 8). After the pump radiation filter 808, the measurement radiation 802 may be imaged onto a structure 810 to be measured. The structure may for example be a target structure for a lithographic process, for example as described above. The structure may be present on a substrate. The substrate comprising a structure to be measured may also be referred to as a sample. Optical elements 812 may be provided for guiding the radiation from the source assembly to the structure, and elsewhere in the metrology setup 800. The structure may be a lithographically patterned structure. The measurement radiation may be diffracted, reflected, and/or scattered by the structure.

One or more detectors 814 may be provided to capture the diffracted, reflected, and or scattered measurement radiation 802. Multiple individual detectors may be positioned as part of the metrology setup, in order to capture a large numerical aperture (NA). The positioning of the detectors 814 relative to the structure 810 and measurement radiation beam 802 may be important for capturing a large NA. It may further be desirable to obtain a large fill factor, that is to say, within the NA of the plurality of detectors, a large area is captured by the sensing parts of the detectors 814. This may not always be straightforward. For example, mechanical mounting structures for a detector may block radiation. Radiation incident on such non-sensing structures is not measured by the detectors. A high NA may be advantageous because it is able to capture diffraction from smaller pitched targets, that is to say, smaller dimensions on the structure. The detectors may also comprise a spectrally resolved detector 814A. This detectors may be used for detecting the zeroth order diffracted radiation from the structure 810. A grating 816, which is optional, may be provided for spatially directing radiation of different wavelengths to the detector 814A.

In order to protect the detectors and/or the structure, the intense pump radiation beam 803 exiting from the source assembly 802 may be removed from the optical path of the measurement radiation beam 802 (also referred to as rejected). A majority of the pump radiation 803 should be removed before the measurement radiation is focused onto a structure. Several pump radiation rejection schemes exist, including for example the filter 808 shown in figure 8. Other pump radiation rejection techniques may be used alternatively and/or additionally to a filter 808.

One type of filter for removing pump radiation 803 may be a thin film transmissive filter. Such a thin film filter may be configured to have a high transmissibility for at least one portion of the spectrum (e.g. the measurement radiation 802 wavelength range), and a low transmissibility for at least another portion of the spectrum (e.g. the pump radiation 803 wavelength range). The non-transmitted radiation may be reflected and/or absorbed by the filter.

A thin film filter may often be implemented as a last (or late-stage) rejection step, because the thin film may not be able to withstand high power radiation beams. An advantage of a thin film filter may be that it may offer a high rejection ratio between pump radiation 803 and measurement radiation 802. That is to say, a thin film filter may reject a lot of the pump radiation wavelengths, while transmitting a large portion of the measurement radiation wavelengths. The high rejection ratio may be needed in order to achieve sufficient filtering of the pump radiation away from the measurement radiation. The rejection ratio may be of an order of around 10¹². The filter thickness may be selected to achieve a balance between high transmission of measurement radiation and low residual transmission of other radiation that transmits through the filter. A high transmission of the measurement radiation may be desirable for a high throughput of the setup, which may for example be in a metrology or inspection tool. However, residual transmission of pump radiation may be undesirable as it may reach the substrate and/or the detectors.

Other unwanted radiation may be present in a metrology setup. A filter, such as a thin film filter, may be mounted onto a filter wheel assembly. A filter wheel assembly may be not perfectly radiation tight around the filter itself. Leakage of unwanted radiation past the filter wheel may reach the structure am/or the detectors. Positioning of the substrate may be performed using stages. Typically, such states for positioning the substrate may have optical encoders and/or interferometers to track and/or align the substrate position. The positioning may be to position the structure to be measured in the optical path of the measurement radiation. For a positioning system providing 6 degrees of freedom (translation and tilt around three spatial dimensions), multiple encoders and/or interferometers may be present inside the chamber of the substrate. Each of these encoders and/or interferometers may produce unwanted radiation (e.g. used to achieve the positioning) that may also reach the detectors. Other components that produce radiation may also be present inside the measurement chamber.

Residual radiation transmitted through the filter, radiation leaked around the filter wheel, as well as radiation coming from encoders, interferometers, and/or other components, may contribute to unwanted radiation reaching the substrate, structure and/or the detectors. This may result in damage to the substrate, structure, and/or detector(s). It may alternatively or additionally result in a reduction of the quality of the measurement of the parameter related to the structure. This unwanted radiation may be referred to as stray radiation.

Placement of a filter relative to the substrate and/or detectors may also present challenges. Filter 808 shown in figure 8 is placed in a suitable location for filtering out pump radiation 803. However, it may be ineffective in filtering out stray radiation coming from directions other than the optical path of the measurement radiation beam. Covering a larger area of incidence to filter radiation from a greater range of directions of incidence may therefore be desirable. Placing a large filter in close proximity to the detectors may seem desirable. However, the size and position of the filter are subject to limitations.

Regarding the size of the filter, a larger filter may cover a larger area in front of a detector, However, manufacturing larger filters (e.g. to cover multiple detectors) may be increasingly difficult with increasing size. In addition, if a single planar filter is used, it cannot be placed close to the substrate without blocking incoming measurement radiation from the source to the substrate. This may limit the achievable NA. A planar filter in combination with an increasing NA of radiation passing through that filter also results in larger angles of incidence (away from perpendicular) of measurement radiation onto the filter. This may result in considerable transmission losses of measurement radiation.

Next to placement of the filter, a second solution for reducing stray radiation reaching the detectors may be to turn off all stray radiation sources. This would include stages, encoders, interferometers and/or any other components using radiation signals. During the time these components are turned off, the substrate position cannot be monitored or adjusted. Once the components are turned back on, the stages must be re-referenced in order to move and be used for accurate positioning again, as their position tracking was lost. Such re-referencing may be time-consuming, and may lead to a major decrease in throughput. This would severely limit viability for commercial application, as throughput may be a major consideration. Avoiding the use of optical encoders and/or interferometers for substrate positioning presents difficult challenges and may lead to reduced performance in positioning accuracy.

In addition, the stray radiation after the filter wheel assembly should be removed. This can be done with careful design of the filter wheel assembly. This may require significant engineering effort due to the high pump radiation rejection needed. This likely impacts the ease of changing the filter, which may be a consumable. It may also negatively impact measurement radiation transmission.

Described herein are several schemes to allow a high NA detector setup with improved stray radiation rejection.

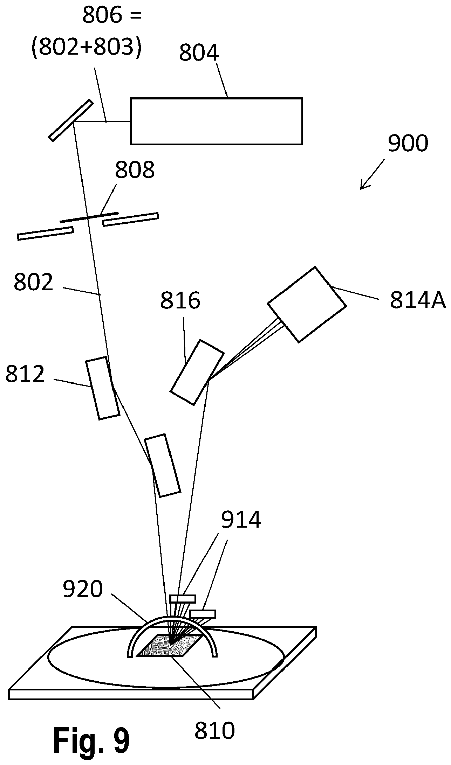

Figure 9 depicts an apparatus 900 for measuring a parameter of a structure related to a semiconductor manufacturing process. The apparatus described in relation to figure 9 may comprise some or all of the features described in relation to figure 8 above. The apparatus comprises a source assembly 804 configured to provide measurement radiation 802 for irradiating a structure on a substrate. The measurement radiation 802 comprises one or more first wavelengths. The apparatus further comprises a filter 920 arranged to receive scattered measurement radiation that has scattered from the structure 810, the structure being irradiated by the measurement radiation 802. The filter 920 is configured to transmit radiation at the one or more first wavelengths, such as the scattered measurement radiation. The filter is further configured to filter out radiation at one or more second wavelengths. The one or more second wavelengths do not overlap with the one or more first wavelengths. The filter comprises a film with a curvature in at least one direction. The apparatus 900 may further comprise one or a plurality of detectors 914 configured to detect radiation at the wavelengths of the measurement radiation. The detectors 914 are located downstream of the filter, and are positioned to receive scattered measurement radiation in order to measure the parameter of the structure.

An advantage of the apparatus 900 described in relation to figure 9 above, is that a curved filter 920 is provided. Due to the curvature of the filter 920, the angle of incidence of radiation onto the filter 920 may be closer to normal incidence for a larger range of angles of incidence. This may be relevant for detecting scattered measurement radiation, as the radiation may be scattered by the structure in a large range of angles. The proportion of radiation transmitted through the filter may be higher as the angle of incidence is closer to normal incidence, e.g. due to the shorter path length through the filter at normal incidence. In one embodiment, the filter is curved such that different orders and/or different colours of the scattered measurement radiation from the target are perpendicular to the curved filter, i.e. the proportion of radiation transmitted through the filter may be normal incidence.

A further advantage may be that the curvature of the filter 920 may result in a greater separation between the substrate/structure and the middle of the filter, thereby reducing a volume conflict in the proximity around the substrate. An advantage of the greater separation may be that more space is available for the incident measurement radiation path, and/or the one or a plurality of detectors for measuring scattered radiation. The curvature centre of the curved filter, may be at the target spot of the measurement radiation on the structure. Having the centre of curvature at the target spot of the incident measurement radiation on the structure may provide the highest volume conflict removal.

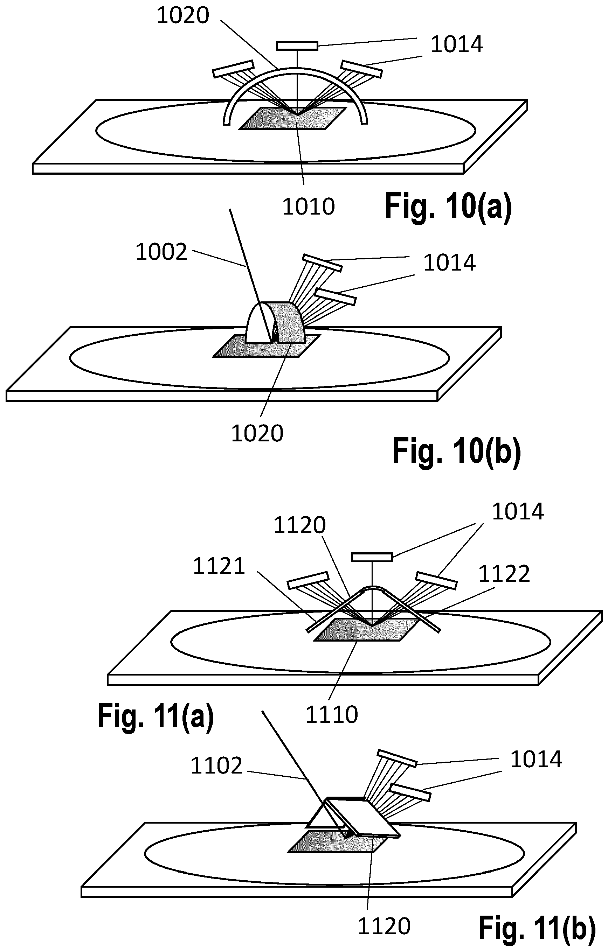

In some implementations, substantially the entire surface of the filter may be curved. This may be illustrated for example in figures 10(a) and 10(b). The curved filter 1020 may for example have a cylindrical or elliptic cylindrical shape. It may also be possible to provide a filter with a double curved surface, also referred to as a surface curved in two directions. An example of a doubly curved surface is a hemisphere or elliptic hemisphere.

The curved filter 1020 may be positioned in such a way relative to the angle of incidence of the incident measurement radiation 1002, such that the incident measurement radiation beam 1002 does not pass through the filter 1020 before reaching the structure 1010. After being scattered, diffracted, and/or reflected off structure 1010, the radiation may pass through filter 1020 before reaching the detectors 1014. In some implementations, a filter is not curved along its entire surface. A filter 1120 may for example comprise two planar 1121 and 1122 areas that are angled relative to each other, as illustrated in figures 11(a) and 11(b). The planar areas 1121 and 1122 may for example form a V-shape. The planar areas may be joined in the middle to form a single continuous filter 1120. The joining area may be angular, connecting one planar surface to the other. Alternatively, the joining area may comprise a curved surface section for connecting the two planar surfaces. The radius of the curve joining the two planar surfaces may be chosen arbitrarily. Similarly to the implementation described in relation to figures 10(a) and 10(b) above, the filter may be positioned such that incident measurement radiation 1102 reaches the structure 1110 without needing to pass through the filter. The scattered, reflected and/or diffracted radiation from the structure 1110 may then pass through the filter 1120 before reaching detectors 1114. Although a piecewise planar structure may provide a angles of incidence that are further away from nominal incidence compared to a curved surface, such a filter may be easier to manufacture, and may still provide significant advantages compared to a single planar filter. In another embodiment, the filter 1120 may for example comprise more than two planar areas that are angled relative to each other, and at least part of the planar sections are connected by a fold portion(s). In another embodiment, the filter 1120 may for example comprise more than two planar areas that are angled relative to each other, and at least two of the planar sections are connected by a piece of metal, optionally the piece of metal has a V-shape.

The one or more first wavelengths of the measurement radiation may comprise SXR and/or EUV radiation. The measurement radiation may for example comprise one or more wavelengths in a range from 0.01 nm - 50 nm, or 0.01 nm - 20 nm, or 1 nm - 10 nm, or 10 nm - 20 nm. The measurement radiation may comprise high harmonic generated radiation. The source assembly 804 may comprise a high harmonic generation system.

The one or more second wavelengths of stray radiation may comprise pump radiation used by the source assembly for generating measurement radiation. The one or more second wavelengths may additionally and/or alternatively comprise stray radiation generated by one or more components of the apparatus 900. The components may for example include encoders for positioning stages for the substrate and/or an interferometer system for alignment of positioning stages and/or the radiation beam. Wavelengths of stray radiation may for example comprise one or more wavelengths in the infrared and/or visible part of the electromagnetic spectrum. The pump radiation may comprise one or more wavelengths in a range from 200 nm to 10 µm. The pump radiation may for example comprise one or more wavelengths obtainable from a commercially available high intensity radiation source.

The wavelengths of the measurement radiation may not overlap with the measurements of the stray radiation to be filtered out by the filter 920, 1020, 1120 of the apparatus. The wavelengths of the measurement radiation may all be comprised within a measurement wavelength range. In some embodiments, the measurement radiation may comprise all, or substantially all, wavelengths in the measurement wavelength range. In other embodiments, some discrete wavelengths and/or wavelength subranges of the measurement wavelength range may be absent from the measurement radiation.

The curved filter may be configured to block some wavelengths and transmit others. The filter may for example comprise a high pass filter and/or a band pass filter. Specifically, the filter may be configured to transmit measurement radiation wavelengths, while blocking out wavelengths of stray radiation.

In order to achieve the transmission/reflection properties for the desired wavelength ranges described above, a suitable material for the filter may be selected. The filter described herein may comprise for example one or more of zirconium, aluminium, carbon, boron, silicon, yttrium, silver.

The thickness of the filter film may be in a range from 50 nm to 800 nm, optionally from 50 nm to 300 nm. In some case, the filter film may have a thickness up to 2 µm. The filter film thickness may be chosen to be sufficiently thin to minimise transmission losses of measurement radiation. The filter may be chosen to be thick enough to avoid damage by incident radiation and blocking stray radiation. If the film is too thick, the transmission losses of the measurement radiation may be too high, while if the film is too thin, the film may break easily due to too low strength. In some example implementations, the filter may have a preferred thickness of 150 to 250 nm, which provide both relatively low transmission losses and good strength.

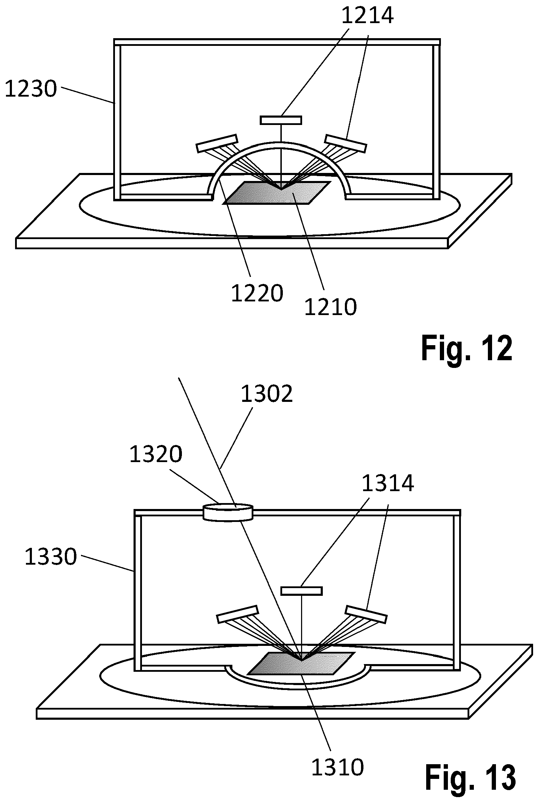

In some implementations, the apparatus may comprise an enclosure 1230 that is at least partially radiation-tight. The enclosure may be a geometric construction around at least the detectors of the apparatus. The enclosure may be radiation-tight for wavelengths of stray radiation. The enclosure may be radiation-tight for the measurement radiation wavelengths. An example enclosure 1230 is illustrated in figure 12. The filter 1220 may form part of and/or be connected to the enclosure 1230. The plurality of detectors 1214 may be located inside or outside the enclosure 1230.

The structure 1210 may be located outside the enclosure 1230. Measurement radiation may be incident onto structure 1210 outside the enclosure 1230. The scattered, diffracted, and/or reflected from the structure 1210 may pass through filter 1220 and enter the enclosure 1230. The enclosure may be radiation-tight, except for an area covered by filter 1220. Such an enclosure setup may provide an environment for the detectors in which only measurement radiation is able to enter the enclosure through the filter 1220. This may further reduce any stray radiation to reach the detectors.

The enclosure may comprise a pattern of one or more grooves configured to trap unwanted radiation. The grooves may for example be V-shaped and/or U-shaped grooves. The grooves may stop stray radiation from reflecting off the surface of the enclosure, thereby hindering propagation and/or travel of unwanted radiation inside the enclosure.

In a separate implementation disclosed herein, an apparatus for measuring a parameter of a structure relating to a lithographic manufacturing process may be provided. The apparatus may have some or all of the features described in relation to figures 8(a) and 8(b) above. The placement of the filter may be different compared to the apparatus described in figure 9. The alternative placement of the filter is illustrated in figure 13. A filter 1320 may be placed upstream of the structure 1310. The filter 1320 may be planar. The filter may comprise a film, as described above. The film/filter may be held by a frame. The frame may be placed in the opening of an enclosure 1330 as described above. Other than the opening in which the filter is placed, the enclosure may be radiation-tight. The structure 1310 may be placed inside the enclosure 1330. In another embodiment, the structure 1310 may be placed outside the enclosure 1330. The detectors 1314 may be placed inside the enclosure 1330. Measurement radiation 1302 may enter the enclosure 1330 through the filter 1320 placed in the opening of the enclosure. A surface of the enclosure is facing the substrate, which may for example be placed 10 µm to 2 mm from the surface of the target structure, for example in a range from 100 - 500 µm. The surface may have a coating. Optionally the coating is radiation absorbing for wavelengths of stray radiation to trap unwanted radiation. Optionally, the surface may comprise a pattern of one or more grooves configured to trap unwanted radiation. The grooves may for example be V-shaped and/or U-shaped grooves. The grooves may stop stray radiation from reflecting off the surface, thereby hindering propagation and/or travel of unwanted radiation inside the enclosure.

However, stray radiation could enter the enclosure through the opening. In order to reduce the risk of interaction of the structure and/or detectors with stray radiation, the opening may therefore be placed close to the surface of the target structure. It may for example be placed 10 µm to 2 mm from the surface of the target structure, for example in a range from 100 - 500 µm. In some implementations, the diameter of the opening may be made as small as possible, e.g. in a range from 100 mm to 40 mm

In an example embodiment, the rejection or stray radiation may be achieved by an enclosure around the detectors. The enclosure may resemble a nose cone in front of the detector. The radiation-tight enclosure may encompass the plurality of detectors. The enclosure may reach up to the substrate comprising the structure. The enclosure may have a small opening around the structure on the substrate to be measured. Due to this small opening, the stray light from the environment is rejected. This is enhanced by a small distance between the enclosure and the substrate, acting like a seal between the substrate and the enclosure. Stray radiation is then less likely to travel in between the enclosure and the substrate without being absorbed along the way. This absorption can be enhanced by providing a coating on the outside and inside of the enclosure that is radiation absorbing for wavelengths of stray radiation. Alternative or additionally, the absorption may be achieved by a suitable surface profile (e.g. V-shaped and/or U-shaped grooves).

In one embodiment, the enclosure may resemble a nose cone in front of the detectors. In this case, dose of the measurement radiation on the detectors is the same as the dose on the structure. This is favourable because that every photon of the measurement radiation which illuminates the structure is detected (within the detection NA), such that minimal amount of sample damage/carbon growth, which may be caused by the measurement radiation and cause structure drift, can be obtained to achieve a given SNR (signal noise ratio) on the detectors. Minimizing structure drift in this way may lead to a better parameter inference, especially in use cases for example of profilometry.

In some implementations, an enclosure may be provided that has two chambers. A first chamber may be provided upstream of the structure, as a first step for filtering out stray radiation. A second chamber may be provided downstream of the structure, as described in relation to figure 12 above. Although a twochamber setup may further improve stray radiation rejection, it also involves more complex enclosure construction.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Further embodiments are disclosed in the subsequent list of numbered clauses:
1. An apparatus for measuring a parameter of a structure related to a semiconductor manufacturing process, the apparatus comprising:
   a source assembly configured to provide measurement radiation having one or more first wavelengths for irradiating the structure on a substrate;
   a filter arranged to receive scattered measurement radiation that has scattered from the structure, wherein the filter is configured to transmit the scattered measurement radiation at the one or more first wavelengths and filter out radiation at one or more second wavelengths, wherein the filter comprises a film with a curvature in at least one direction; and
   a plurality of detectors, located downstream of the filter, configured to detect the filtered scattered radiation configured to measure the parameter of the structure.
2. An apparatus according to clause 1, wherein substantially the entire surface of the film is curved.
3. An apparatus according to clause 1, wherein the film comprises two or more planar sections connected by a fold portion of the film.
4. An apparatus according to any of the preceding clauses, wherein the one or more second wavelengths are in a range from 200 nm to 10 µm.
5. An apparatus according to any of the preceding clauses, wherein the radiation at one or more second wavelengths comprises pump radiation used by the source assembly for generating the measurement radiation.
6. An apparatus according to any of the preceding clauses wherein the radiation at one or more second wavelengths comprises stray radiation generated by one or more components of the apparatus.
7. An apparatus according to any of the preceding clauses, wherein the measurement radiation comprises one or more wavelengths in a range of 0.01 nm - 50 nm, or 0.01 nm - 20 nm, or 1 nm - 10 nm, or 10 nm - 20 nm.
8. An apparatus according to any of the preceding clauses, wherein the source assembly comprises a high harmonic generation source.
9. An apparatus according to any of the preceding clauses, wherein the filter film comprises at least one of zirconium, aluminium, carbon, boron, silicon, yttrium, silver.
10. An apparatus according to any of the preceding clauses, wherein the filter film has a thickness in a range from 50 nm to 800 nm.
11. An apparatus according to clause 10, wherein the filter film has a thickness in a range from 150 nm to 250 nm.
12. An apparatus according to any of the preceding clauses, wherein the apparatus further comprises an enclosure that is at least partially radiation-tight.
13. An apparatus according to clause 12, wherein the plurality of detectors are located inside the enclosure.
14. An apparatus according to any of clause 13, wherein the structure is located outside the enclosure.
15. An apparatus according to any of clauses 12 - 14, wherein a surface of the enclosure comprises one or more grooves or coating configured to trap unwanted radiation.
16. An apparatus according to any of the preceding clauses, wherein the structure comprises a target structure comprising one or more diffracting patterns.
17. An apparatus for measuring a parameter of a structure related to a semiconductor manufacturing process, the apparatus comprising:
   a source assembly configured to provide measurement radiation having one or more first wavelengths for irradiating the structure on a substrate;
   a filter arranged to receive scattered measurement radiation that has scattered from the structure, wherein the filter is configured to transmit the scattered measurement radiation at the one or more first wavelengths and filter out radiation at one or more second wavelengths, wherein the filter comprises a film with a curvature in at least one direction;
   a plurality of detectors, located downstream of the filter, configured to detect the filtered scattered radiation configured to measure the parameter of the structure; and
   an enclosure configured to comprise the structure and the plurality of detectors, wherein the enclosure is at least partially radiation-tight, and wherein the enclosure comprises an opening for passing radiation and wherein the filter is placed inside the opening.
18. An apparatus according to any of the preceding clauses, wherein the filter is curved such that different orders and/or different colors of the scattered measurement radiation are perpendicular to the curved filter.
19. A metrology tool comprising the apparatus of any of the preceding clauses.
20. An inspection tool comprising the apparatus of any of clauses 1 - 18.
21. A lithographic apparatus comprising an apparatus according to any of clauses 1 - 18.
22. A litho cell comprising an apparatus according to any of clauses 1 - 18.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (nonvacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, includes radio waves, microwaves, infrared, (visible) light, ultraviolet, X-rays, and gamma rays.

While specific embodiments have been described above, it will be appreciated that one or more of the features in one embodiment may also be present in a different embodiment and that features in two or more different embodiments may also be combined.

## Claims

1. An apparatus for measuring a parameter of a structure related to a semiconductor manufacturing process, the apparatus comprising:
a source assembly configured to provide measurement radiation having one or more first wavelengths for irradiating the structure on a substrate;
a filter arranged to receive scattered measurement radiation that has scattered from the structure, wherein the filter is configured to transmit the scattered measurement radiation at the one or more first wavelengths and filter out radiation at one or more second wavelengths, wherein the filter comprises a film with a curvature in at least one direction; and
a plurality of detectors, located downstream of the filter, configured to detect the filtered scattered radiation configured to measure the parameter of the structure.

2. An apparatus according to claim 1, wherein substantially the entire surface of the film is curved.

3. An apparatus according to claim 1, wherein the film comprises two or more planar sections connected by a fold portion of the film.

4. An apparatus according to any of the preceding claims, wherein the one or more second wavelengths are in a range from 200 nm to 10 µm.

5. An apparatus according to any of the preceding claims, wherein the radiation at one or more second wavelengths comprises pump radiation used by the source assembly for generating the measurement radiation or stray radiation generated by one or more components of the apparatus.

6. An apparatus according to any of the preceding claims, wherein the measurement radiation comprises one or more wavelengths in a range of 0.01 nm - 50 nm, or 0.01 nm - 20 nm, or 1 nm - 10 nm, or 10 nm - 20 nm.

7. An apparatus according to any of the preceding claims, wherein the source assembly comprises a high harmonic generation source.

8. An apparatus according to any of the preceding claims, wherein the filter film comprises at least one of zirconium, aluminium, carbon, boron, silicon, yttrium, silver.

9. An apparatus according to any of the preceding claims, wherein the filter film has a thickness in a range from 50 nm to 800 nm, optionally the filter film has a thickness in a range from 150 nm to 250 nm.

10. An apparatus according to any of the preceding claims, wherein the apparatus further comprises an enclosure that is at least partially radiation-tight.

11. An apparatus according to claim 10, wherein the plurality of detectors are located inside the enclosure.

12. An apparatus according to any of claim 11, wherein the structure is located outside the enclosure.

13. A metrology tool comprising the apparatus of any of the preceding claims.

14. A lithographic apparatus comprising an apparatus according to any of claims 1 - 12.

15. A litho cell comprising an apparatus according to any of claims 1 - 12.
